# EUROPEAN PATENT APPLICATION

(11) **EP 1 884 990 A1**
(43) Date of publication of application: **06.02.2008**
(21) Application number: 06745589.9
(22) Date of filing: 24.04.2006
(51) Int. Cl.: H01L 21/52, H01L 21/683, B29C 63/02, B29C 65/02

(54) **ADHERING APPARATUS**

(30) Priority: 19.05.2005 JP 2005146482; 28.07.2005 JP 2005218543
(71) Applicant: Lintec Corporation, Tokyo 173-0001 (JP)
(72) Inventor: KOBAYASHI, Kenji c/o. LINTEC CORPORATION, Itabashi-ku Tokyo 1730001 (JP); TSUJIMOTO, Masaki c/o. LINTEC CORPORATION, Itabashi-ku Tokyo 1730001 (JP); YOSHIHOKA, Takahisa c/o. LINTEC CORPORATION, Itabashi-ku Tokyo 1730001 (JP)
(74) Representative: Grünecker, Kinkeldey, Stockmair & Schwanhäusser Anwaltssozietät
(86) International application number: PCT/JP2006/308511
(87) International publication number: WO 2006/123509

(57) **Abstract**

A sticking apparatus includes a sticking table 21 for supporting a semiconductor wafer W and a sticking unit 24 that peels off an adhesive sheet S1 from a release liner PS and sticks the adhesive sheet to the semiconductor wafer W. The sticking unit 24 has a detector 60. The detector 60 is disposed above a feed-out path of a raw strip sheet L for detecting a displacement amount S of the adhesive sheet S1 in the lateral direction perpendicular to the feed-out direction thereof. When the displacement amount S is detected, a displacement correction device 51 is activated and the sticking table 21 is moved by a distance corresponding to the displacement amount S, thereby the adhesive sheet S1 can be stuck onto the semiconductor wafer W in accordance with the outer shape thereof. The adhesive sheet S1 is stuck onto the wafer W by a sticking roll 61, which is brought into a contact with the release liner PS to impart a pressing force thereto.

## Description

### Technical field

The present invention relates to a sticking apparatus, in particular to a sticking apparatus capable of precisely sticking an adhesive sheet to a predetermined position of a plate-like object when sticking the adhesive sheet to the plate-like object such as a semiconductor wafer.

### Background Art

After cutting a semiconductor wafer (hereinafter, simply referred to as "wafer") formed with circuit surface thereon into separate chips, each of the chips is picked up and die-bonded onto a lead frame. This die bonding is carried out by previously sticking a heat-sensitive adhesive sheet for die bonding in the process of wafer processing.

As for the sticking method of the adhesive sheet, there are available the following methods. That is, a method in which, using a raw strip sheet in which a release liner strip is temporarily stuck with an adhesive sheet strip, after sticking the adhesive sheet peeled off from the release liner to the wafer, the adhesive sheet is cut off along the periphery of the wafer (refer to Patent document 1); and a method in which a sheet previously formed in a plane shape corresponding to the outer shape of the wafer is peeled off from a release liner and stuck to the wafer (refer to Patent document 2).

[Patent document 1] Japanese Patent Application Laid-open No. 2003-257898
[Patent document 2] Japanese Patent Application Laid-open No. HEI 7-195527

### Disclosure of the Invention

### Problem to be solved by the Invention

However, in the arrangement disclosed in the patent document 1, a periphery-cutting device is indispensable for the sticking apparatus to cut off the periphery of the adhesive sheet after sticking the same. Therefore, there arise such problems that the structure of the apparatus becomes complicated and the wafer suffers damage on the periphery thereof due to positional error between the periphery-cutting device and a sticking table supporting the wafer.

On the other hand, in the case where the sheet, which has been previously formed in accordance with the shape of the wafer, is stuck to the wafer, there arises such a problem that the adhesive sheet fails to be stuck to a predetermined position of the wafer due to a positional displacement at a point feeding out a raw strip sheet, and the adhesive sheet is stuck thereon in a state being displaced in a lateral direction. In this viewpoint, the patent document 2 has proposed such an arrangement that, even when a positional displacement of raw strip sheet occurs at a point feeding out the sheet, the displacement is corrected and the adhesive sheet is stuck to a predetermined position of the wafer.

However, the apparatus disclosed in the patent document 2 adopts the following method; i.e., in order to detect the displacement of the adhesive sheet, the feeding out of the raw strip sheet is stopped once to take an image with an imaging device. Therefore, there resides such a problem that continuous processing is prevented resulting in a largely reduced efficiency of the processing. Moreover, a camera or the like for taking image is indispensable. Therefore, there also arises such a problem that the cost for the system for controlling the camera increases resulting in a loss in an aspect of cost efficiency.

### [Object of the Invention]

The present invention has been proposed in view of the above disadvantages. An object of the present invention is to provide a sticking apparatus capable of sticking the adhesive sheet to a plate-like object by correcting the amount of displacement even when the adhesive sheet is displaced in a direction perpendicular to the feed-out direction when feeding out the raw strip sheet.

Moreover, another object of the present invention is to provide a sticking apparatus employing a method to stick the adhesive sheet, which is previously cut into a surface shape corresponding to the outer shape of the wafer, without the periphery cutting device.

Still another object of the present invention is to provide a sticking apparatus capable of sticking without giving any damage on the surface of the adhesive sheet.

### Means for Solving Problems

In order to achieve the above objects, the present invention adopts the following arrangement; i. e., a sticking apparatus, which includes:
a sticking table for supporting a plate-like object; and
a sticking unit that peels off an adhesive sheet having a plane shape corresponding to the plate-like object in the feeding process of a raw strip sheet temporarily stuck with the adhesive sheet on a release liner and sticks the sheet onto the plate-like object,
wherein sticking apparatus is provided with a detector disposed above a feed-out path of the raw strip sheet for detecting displacement amount in the lateral direction perpendicular to the feed-out direction of the adhesive sheet and a displacement correction device that, when a displacement of the adhesive sheet is detected by the detector, corrects the displacement,
the detector detects the displacement amount without stopping the feed-out operation of the raw strip sheet.

Also, the present invention adopts the following arrangement; i.e., a sticking apparatus, which includes:
a sticking table for supporting a semiconductor wafer; and
a sticking unit that peels off an adhesive sheet having a plane shape corresponding to the semiconductor wafer in the feeding process of a raw strip sheet temporarily stuck with the adhesive sheet on a release liner, and sticks the sheet onto the semiconductor wafer,
wherein sticking apparatus is provided with a detector disposed above a feed-out path of the raw strip sheet for detecting displacement amount in the lateral direction perpendicular to the feed-out direction of the adhesive sheet and a displacement correction device that, when a displacement of the adhesive sheet is detected by the detector, adjusts the position of the sticking table in accordance with the displacement,
the detector detects the displacement amount without stopping the feed-out operation of the raw strip sheet.

Further, the present invention adopts the following arrangement; i.e., a sticking apparatus, which includes:
a sticking table for supporting a plate-like object; and
a sticking unit that peels off an adhesive sheet having a plane shape corresponding to the plate-like object in the feeding process of a raw strip sheet temporarily stuck with the adhesive sheet on a release liner, and sticks the sheet onto the plate-like object,
wherein the sticking unit sticks the adhesive sheet onto the plate-like object while performing the feeding out of the adhesive sheet, pressing of the adhesive sheet and peeling off the adhesive sheet from the release liner simultaneously.

Furthermore, the present invention may adopt the following arrangement; i.e., a sticking apparatus, which includes:
a sticking table for supporting a plate-like object; and
a sticking unit that peels off an adhesive sheet having a plane shape corresponding to the plate-like object in the feeding process of a raw strip sheet temporarily stuck with the adhesive sheet on a release liner, and sticks the sheet onto the plate-like object,
wherein the sticking unit sticks the adhesive sheet onto the plate-like object while performing winding of the adhesive sheet, pressing of the adhesive sheet and peeling off of the adhesive sheet from the release liner simultaneously from a state where the adhesive sheet is fed out to a position facing the upper surface of the plate-like object.

The sticking apparatus, which is capable of performing the feeding out or winding of the adhesive sheet and the pressing of the adhesive sheet simultaneously, may adopt an arrangement, which further includes a detector disposed above a feed-out path of the raw strip sheet for detecting displacement amount of the adhesive sheet in lateral direction perpendicular to the feed-out direction thereof, and a displacement correction device that, when a displacement of the adhesive sheet is detected by the detector, corrects the displacement,
the detector detects the displacement amount without stopping the feed-out operation of the raw strip sheet.

The present invention adopts an arrangement, in which the adhesive sheet has a substantially circular shape, and the detector detects a chord length of the adhesive sheet along the feed-out direction to determine the displacement amount.

Further, the detectors in the present invention are disposed at the both sides in lateral direction at regular intervals with respect to a reference centerline along the feed-out direction.

Furthermore, the adhesive sheet may be a heat-sensitive adhesive sheet for die bonding.

### Effect of the Invention

According to the present invention, since the raw strip sheet, which is temporarily stuck with the adhesive sheet having a shape corresponding to the shape of the plate-like object on the release liner, is used, a device for cutting the raw strip sheet along the periphery of the plate-like object can be eliminated.

Also, when detecting the displacement of the fed out adhesive sheet, the feed-out operation of the raw strip sheet does not have to be stopped. Therefore, compared with the case of intermittent feeding operation, the efficiency of the sticking operation of the adhesive sheet can be largely increased.

Further, there is adopted such an arrangement for correcting detected displacement that the position of the table, which supports the plate-like object, is adjusted. In other words, since it suffices that the table has to be moved only by a distance equivalent to the displacement amount in lateral direction based on the error in the feed-out path of the raw strip sheet, the mechanism for correcting the displacement can be arranged extremely simply.

Furthermore, the sticking unit is arranged so as to carry out the feeding out or winding operation of the adhesive sheet, the pressing of the adhesive sheet and the peeling off of the adhesive sheet from the release liner simultaneously. Therefore, since the pressing force is imparted to the adhesive sheet being interposed by the release liner, the adhesive sheet can be stuck to the plate-like object without being damaged on the surface thereof.

### Brief Description of the Drawings

[Fig. 1]

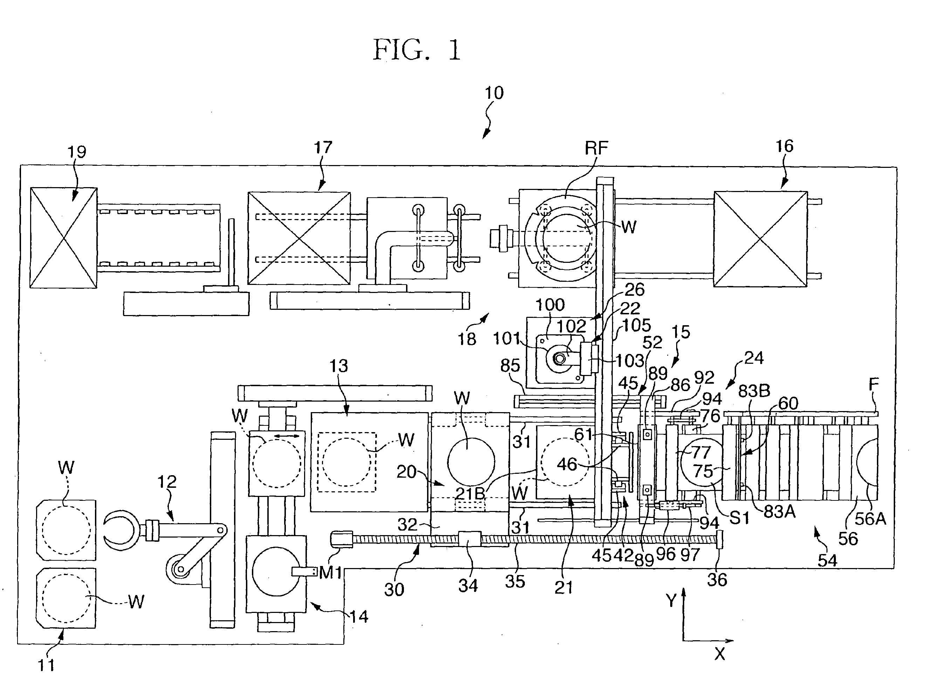

   Fig. 1 is a plan view schematically showing entire arrangement of a wafer processing system in accordance with the embodiment.
[Fig. 2]

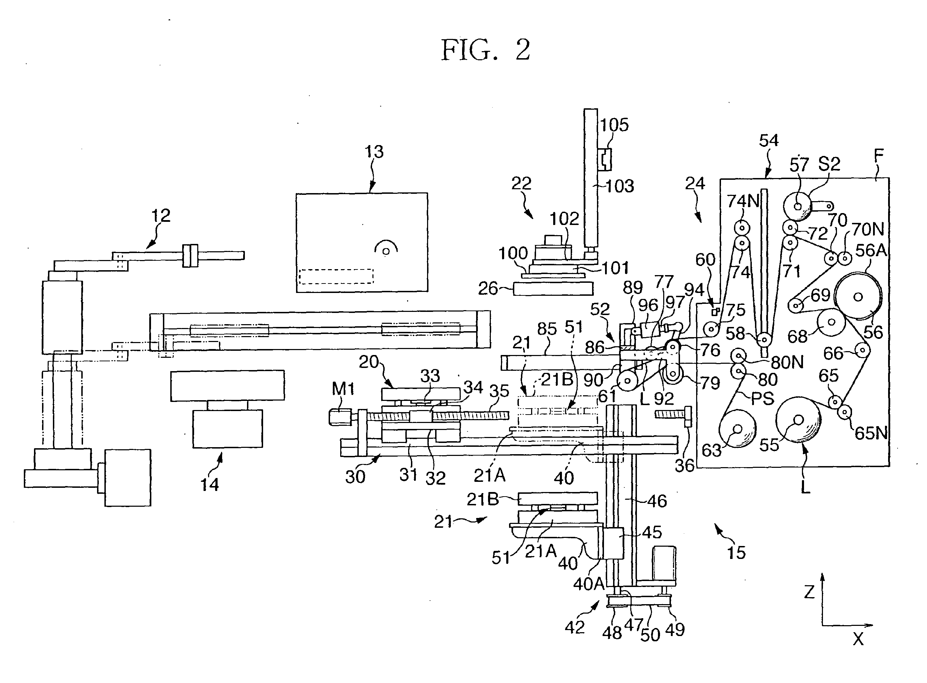

   Fig. 2 is a front elevation showing a part of Fig. 1 including a sticking apparatus.
[Fig. 3]

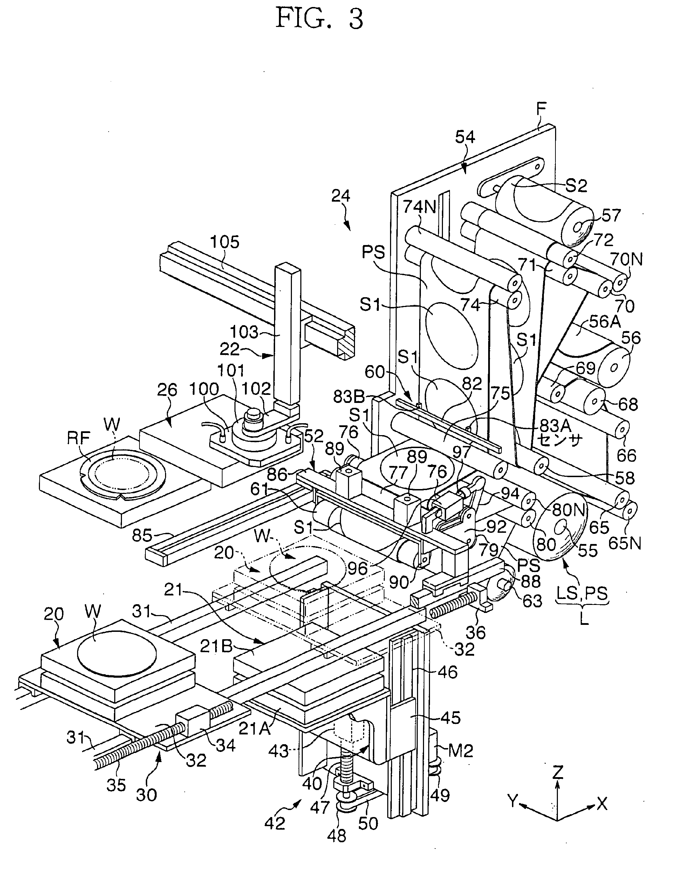

   Fig. 3 is a perspective illustration schematically showing the sticking apparatus.
[Fig. 4]

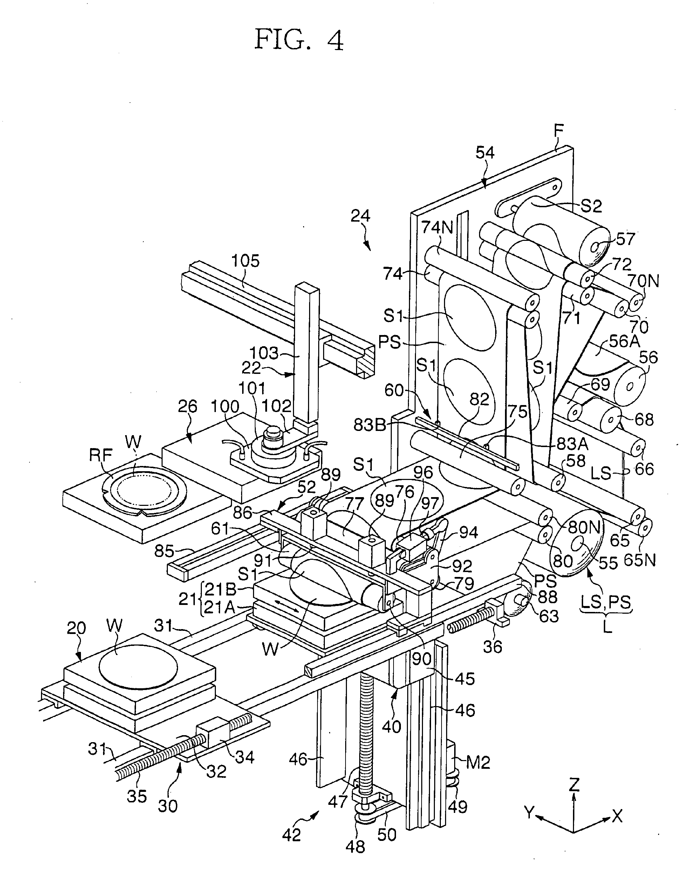

   Fig. 4 is a perspective illustration schematically showing a middle condition of the sticking operation of adhesive sheet by a sticking roll moving device.
**[Fig. 5]**

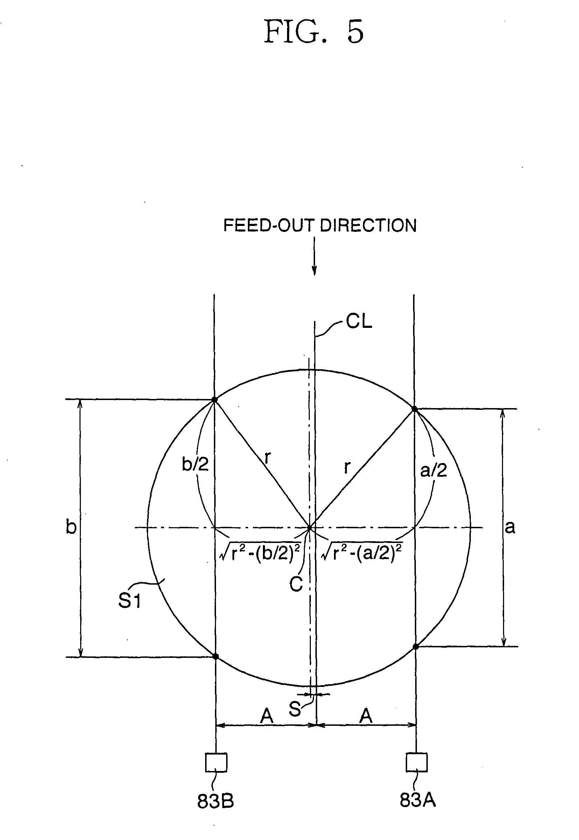

   Fig. 5 is a diagram for illustrating the principle of displacement detection with detectors.
[Fig. 6]

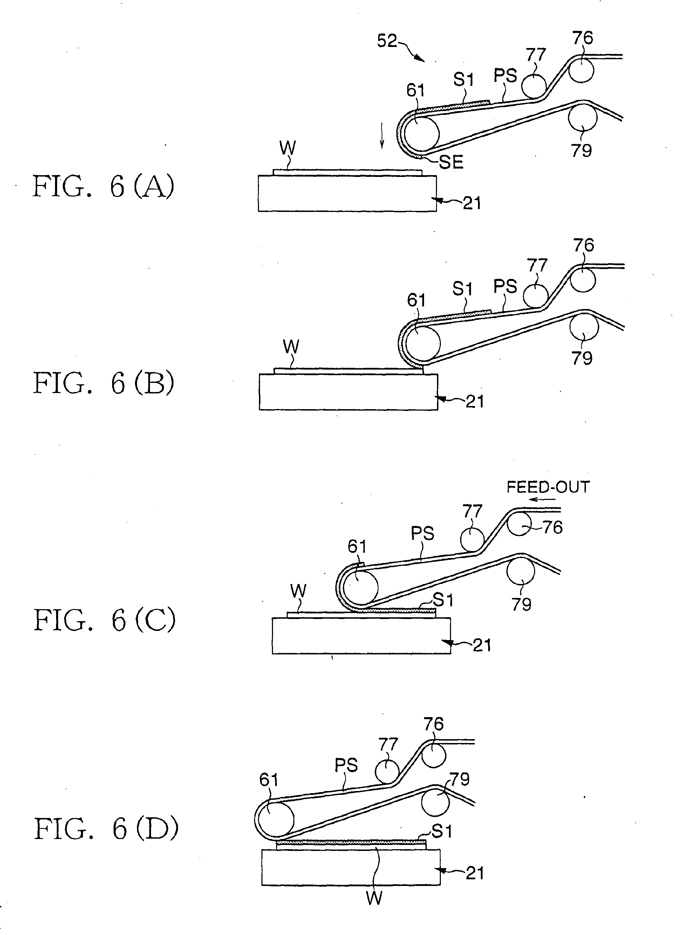

   Figs. 6 (A) to 6(D) are operation explanatory drawings for illustrating feeding-sticking simultaneous operation.
[Fig. 7]

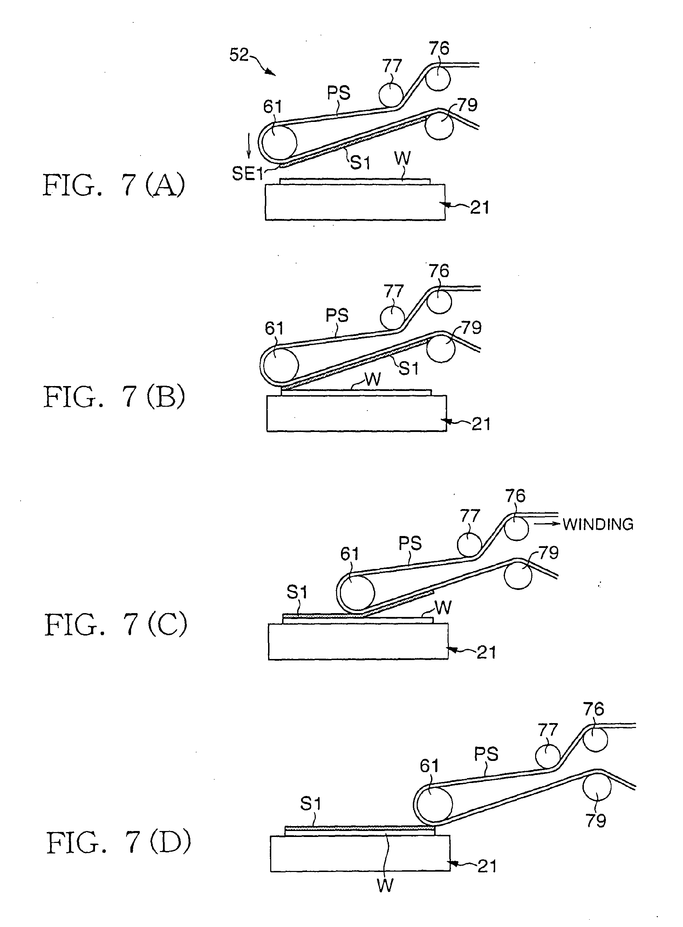

   Figs. 7(A) to 7(D) are operation explanatory drawings for illustrating winding-sticking simultaneous operation.
[Explanation of reference numerals]

- 10: wafer processing system
- 15: sticking apparatus
- 21: sticking table
- 24: sticking unit
- 51: displacement correction device
- 60: detector
- L: raw strip sheet
- S1: adhesive sheet (heat-sensitive adhesive sheet)
- PS: release liner
- LS: adhesive sheet material
- W: semiconductor wafer (plate-like object)

### Best Mode for Working the Invention]

Hereinafter, embodiments of the present invention will be described with reference to the drawings.

Fig. 1 is a plan view showing a wafer processing system in accordance with the embodiment. Referring to Fig. 1, a wafer processing system 10 is constructed as a system, which performs a series of processes to stick a heat-sensitive adhesive sheet S1 for die bonding (hereinafter, referred to as "adhesive sheet S1") to the opposite surface of a circuit surface of a wafer W (hereinafter, referred to as "rear surface of wafer W") as a plate-like object, and then mount the wafer W onto a ring frame RF via a dicing tape at the adhesive sheet S1 side.

The wafer processing system 10 includes a cassette 11 which houses wafers W, a robot 12 which sucks and conveys the wafer W taken out from the cassette 11, an ultraviolet irradiation unit 13 which irradiates an ultraviolet ray to a protective tape (not shown) stuck on a circuit surface side of the wafer W, an alignment device 14 for positioning the wafer W, a sticking apparatus 15 which sticks the adhesive sheet S1 to the rear surface of the wafer W subjected to alignment process, a mounting apparatus 18 having a tape sticking unit 16 which mounts the wafer W onto a ring frame RF via the dicing tape on the wafer W stuck with the adhesive sheet S1 and a tape peeling unit 17 for peeling off the protective tape, and a stocker 19 for storing the wafer W from which the protective tape has been peeled off.

The arrangement and apparatuses excluding the sticking apparatus 15; i.e., the cassette 11, robot 12, ultraviolet irradiation unit 13, alignment device 14, mounting apparatus 18 and stocker 19 are substantially the same as those disclosed in the Japanese Patent Application No. 133069/2004, which has been applied by the applicant of the present invention. Therefore, the description will be made as to the sticking apparatus 15 below.

As shown in Fig. 2 and Fig. 3, the sticking apparatus 15 includes a transfer table 20 that receives and supports the wafer W after ultraviolet irradiation, a sticking table 21 on which the wafer W is transferred from the transfer table 20, a transfer unit 22 that sucks and transfers the wafer W from the transfer table 20 to the sticking table 21, a sticking unit 24 that sticks the adhesive sheet S1 to the rear surface side (upper surface side) of the wafer W transferred onto the sticking table 21 and a bonding table 26 that heats the adhesive sheet S1, which is stuck by the sticking unit 24, to completely bond it to the wafer W.

The transfer table 20 is arranged so as to move vertically and to reciprocate between a position where the wafer W at the previous process can be received and a place above the sticking table 21 via a moving unit 30. The moving unit 30 includes a pair of rails 31, 31, a slide plate 32 that moves on the rails 31, 31 being guided thereby, a lifter 33 disposed on the slide plate 32 (refer to Fig. 2), a ball screw shaft 35 that penetrates through a nut 34 which is fixed to the slide plate 32 in a state being screwed therewith and a motor M1 that drives to rotate the ball screw shaft 35 (refer to Fig. 1). In the ball screw shaft 35, a bearing 36 rotatably supports the opposite side of the motor M1. Owing to this, when the motor M1 is driven to rotate forward/reverse, the transfer table 20 reciprocates in the X-direction along the rails 31, 31.

In the sticking table 21, the upper surface thereof is formed as a suction face. The sticking table 21 is a table for sticking the adhesive sheet S1 to the rear surface (upper surface) of the wafer W with the sticking unit 24 in a state the circuit surface side of the wafer W is sucked being interposed by a protective tape (not shown). The sticking table 21 includes a heater for heating the wafer W to a predetermined temperature. The sticking table 21 includes a base table 21A supported by a lifter bracket 40 having a substantially L-like shape viewed from the side and a suction table 21B supported movably along the Y-direction on the base table 21A.

The sticking table 21 is arranged so as to move vertically via a lifter 42. The lifter 42 includes a nut 43 attached to the rear face side of the lifter bracket 40, a pair of lifter side plates 45 connected to the both sides of the lifter bracket 40, a pair of upstanding rails 46 for guiding these lifter side plates 45 in the vertical direction, a ball screw shaft 47 which extends in the vertical direction penetrating through the nut 43, pulleys 48 and 49 fixed respectively to the lower end of the ball screw shaft 47 and to the output shaft of a motor M2 disposed adjacent to the lower end of the upstanding rail 46, and a belt 50 laid around the pulleys 48, 49. The sticking table 21 is arranged so as to move vertically between an escape position shown in Fig. 3 and a sticking position shown in Fig. 4 by means of rotation of the ball screw shaft 47 driven by the motor M2.

Between the base table 21A and the suction table 21B constituting the sticking table 21, a displacement correction device 51 is disposed as schematically shown in Fig. 2. The displacement correction device 51 includes a uniaxial robot so as to allow movement of the suction plate 21B in the Y-direction.

The sticking unit 24 includes a sheet feed-out section 54 supported within a plate-like frame F and a sticking roll moving device 52 provided concomitantly thereto. That is, the sticking unit 24 includes a support roll 55 for supporting, in a state allowing a feed-out of, a rolled raw strip sheet L, in which a strip of an adhesive sheet material LS is temporarily stuck with a strip of release liner PS, a die-cut roll 56 which has a cutter blade 56A that rotates via a motor (not shown) to form the adhesive sheet S1 for sticking by forming a cut having a outer shape corresponding to the outer shape of the wafer W in the adhesive sheet material LS, a collector roll 57 for winding and collecting the outside of the periphery as unnecessary adhesive sheet S2 after the adhesive sheet S1 has been formed, a dancer roll 58 provided concomitantly to the collector roll 57 for ensuring a buffer area, a detector 60, which is disposed in the feed-out path of the raw strip sheet L behind the dancer roll 58 to detect the position of the adhesive sheet S1, a sticking roll 61 which presses and sticks the adhesive sheet S1 onto the wafer W, and a winding roll 63 which rotates via a motor (not shown) to wind the release liner PS with a predetermined tension after the adhesive sheet S1 has been stuck.

Between the support roll 55 and the die-cut roll 56, a drive roll 65 and a nip roll 65N, which are driven by a torque motor (not shown), and a guide roll 66 are disposed; and on the periphery of the die-cut roll 56, a platen roll 68, which is driven following the die-cut roll 56, is disposed opposing thereto. Between the platen roll 68 and the collector roll 57, a guide roll 69, a drive roll 70 and a nip roll 70N driven by a torque motor (not shown) and a drive roll 71 driven to rotate via a motor (not shown) are disposed. The drive roll 71 is provided with a pinch roll 72 to impart a feed-out force to the raw strip sheet L; and the pinch roll 72 is provided with the collector roll 57 being constantly abutted therewith to rotate the collector roll 57 by means of a frictional force so as to wind and collect the unnecessary adhesive sheet S2. Further, the drive rolls 65 and 70 are adapted so as, when forming the cut, to feed out the adhesive sheet S1 while simultaneously controlling the two rolls in a manner of double-shaft tensile force controlling to prevent the adhesive sheet S1 from being elongated or bent.

Between the dancer roll 58 and the sticking roll 61, a drive roll 74 and a nip roll 74N, which are driven by a torque motor (not shown), guide rolls 75 and 76, and a tension roll 77 are disposed. Also, between the sticking roll 61 and the winding roll 63, a guide roll 79, and a drive roll 80 and a nip roll 80N, which are driven by a torque motor (not shown), are disposed. Note that the drive rolls 74 and 80 are adapted so as, when sticking the adhesive sheet S1 to the wafer W, to feed out the adhesive sheet S1 while carrying out double-shaft tensile force controlling in the same manner as described above to prevent the adhesive sheet S1 from being elongated or bent.

The detector 60 includes a stick-like supporting member 82 protruding from the surface of the frame F and a pair of sensors 83A and 83B attached to the supporting member 82 at two points in the longitudinal direction thereof. The sensors 83A and 83B are disposed at the same positions in the right and left direction with respect to a reference centerline CL along the feed-out direction as shown in Fig. 5, and is adapted to detect the chord lengths "a" and "b" of the adhesive sheet S1 along the reference center line CL. Here, the wording "reference center line" means the following; i.e., in the relationship with a center of the wafer W on the sticking table 21, the centerline in design where the center C of the adhesive sheet S1 temporarily stuck on the release liner PS should pass through. Therefore, when the center C passes through outside of the reference centerline CL, it means that the adhesive sheet S1 passes there being displaced either side in lateral direction (right or left direction in Fig. 5). Assuming that the adhesive sheet S1 is fed out with the center C positioned at the left side with respect to the reference center line CL as shown in Fig. 5, the adhesive sheet S1 is in a state being displaced leftward by a distance "S". As for the detecting method of the displacement, according to the embodiment, two methods can be adopted. To be more precisely, for example, based on 1/2 of the chord length "a" detected by the sensor 83A and a predetermined radius "r" of the adhesive sheet S1, length of the remaining side is calculated using the theorem of three squares, and the length is compared with a preset length A (distance between the sensor detection position and the reference center line), thereby the displacement amount S can be determined. Alternatively, as the other method, the length of the remaining left side is calculated in the same manner as described above based on 1/2 of the chord length b detected by the sensor 83B and the radius "r", the difference from the length of the remaining one side at the right side, which is obtained as described above, and the half thereof can be determined as displacement amount S. It is arranged such that the value of the displacement amount S is automatically calculated using a program in a control device (not shown) and the control device stores the value of displacement amount S, and before the relevant adhesive sheet S1 is stuck onto the wafer W, a command is given to a uniaxial robot of the displacement correction device 51 to move the suction plate 21B by a distance equivalent to the displacement amount S in the Y-direction.

The sticking roll moving device 52 includes a uniaxial robot 85 extending parallelly with the rail 31 of the transfer table 20; i.e., in the X-direction, a moving arm 86 extending in the Y-direction being supported by the uniaxial robot 85, a rail 88 extending in the x-direction so as to support the moving arm 86 at the opposite side of the uniaxial robot 85, a pair of up/down cylinders 89, 89 disposed at two points on the upper surface of the moving arm 86, a gate-like frame 90 disposed at the lower face side of the moving arm 86 so as to move in the vertical direction by means of forward/ backward movement of a piston rod 91 (refer to Fig. 4) of the up/down cylinders 89, and a sticking roll 61 rotatably supported by the gate-like frame 90. When the uniaxial robot 85 is activated and the moving arm 86 moves in the x-direction, the adhesive sheet S1, running on the periphery of the sticking roll 61 is pressed onto the wafer W and stuck thereon.

To the both sides of the gate-like frame 90, brackets 92, 92 having a plate-like shape oriented in a substantially vertical plane are fixed, and the guide rolls 76, 79 are supported at the top and the bottom of the brackets 92 shown right side in Fig. 2. On the rotation center shaft of the guide roll 76, a swinging link 94 having substantially L-like shape is attached swingablly, and the tension roll 77 is supported at one end side thereof, and a piston rod 97 of a air cylinder 96 fixed to the upper surface of the moving arm 86 is connected to the other end side thereof. Therefore, the tension roll 77 is provided rotatably with the rotation center shaft of the guide roll 76 being a rotation center by means of the forward/ backward movement of the piston rod 97, and owing to this, a constant tensile force is imparted to the raw strip sheet L between the guide roll 76 and the sticking roll 61.

The transfer unit 22 includes a plate-like suction plate 100 that sucks the wafer W at the lower surface side, a temperature control unit 101 provided at the upper surface side of the suction plate 100, an arm 102 supporting the suction plate 100, a Z-axis cylinder 103 for vertically moving the suction plate 100 and a uniaxial robot 105 that moves the Z-axis cylinder 103 in the Y-direction. The suction plate 100 sucks the wafer W on the transfer table 20 and transfers the wafer W to the sticking table 21 while heating the wafer W to a temperature for temporarily sticking the adhesive sheet S1 After sticking the adhesive sheet S1 to the wafer W, the suction plate 100 transfers the wafer W to the bonding table 26, and transfers the wafer, which has been completely bonded with the adhesive sheet S1 on the bonding table 26, to the mounting apparatus 18. In order to eliminate or reduce the temperature controlling time after transferring the wafer, the transfer unit 22 is arranged so as to control the temperature of the wafer W by means of the temperature control unit 101 during transferring the wafer W from the transfer table 20 to the sticking table 21, during transferring the wafer from the sticking table 21 to the bonding table 26 and during transferring the wafer from the bonding table 26 to the mounting apparatus 18.

The bonding table 26 is disposed in a side area above the sticking table 21 via a frame (not shown). The bonding table 26 is arranged so that the upper surface thereof is the suction face, and heats the wafer W, which is temporarily stuck with the adhesive sheet S1 and transferred from the sticking table 21 via the transfer unit 22, and completely bonds the adhesive sheet S1 to the wafer W.

The wafer W, which has been completely bonded with the adhesive sheet S1 on the bonding table 26, is transferred to the mounting apparatus 18 side via the transfer unit 22 again. On the mounting apparatus 18, the wafer W is mounted on a ring frame RF via a dicing tape (not shown), a protection sheet is peeled off from the circuit surface of the wafer W after mounted, and stored in the stocker 19.

Now, the sticking operation of the adhesive sheet S1 according to the embodiment will be described.

When a wafer W, which has been subjected to ultraviolet radiation process and alignment process, is conveyed to a position above the sticking table 21 via a transfer table 20, the wafer W is sucked by the suction plate 100 of the transfer unit 22. Then, the transfer table 20 returns to a position indicated with a solid line in Fig. 2, while the sticking table 21 rises to a position indicated with a solid line in Fig. 4 and the wafer W is transferred onto the sticking table 21.

On the other hand, at the sticking unit 24 side, the raw strip sheet L is fed out and cuts are formed in the adhesive sheet material LS so as to form the outline of adhesive sheet S1 having a substantially circular shape viewed from the top through the die-cut roll 56 under a tensile force control by the drive rolls 65 and 70. Unnecessary adhesive sheet S2 generated through the cutting is wound to be collected with the collector roll 57 in order, and in the downstream side behind the drive roll 71 in the feed-out direction, the raw strip sheet L in a state the adhesive sheet S1 is temporarily stuck on the release liner PS is fed out in order. Here, as described above, the detector 60 detects a displacement of the adhesive sheet S1 with respect to the reference centerline CL in lateral direction, determines a displacement amount S thereof and stores the same in a control device (not shown).

When the wafer W of which displacement amount S has been determined enters into a sticking posture, the uniaxial robot of the displacement correction device 51 moves the suction table 21B by a distance equivalent to the displacement amount in the Y-direction with respect to the reference center line CL based on the displacement amount S of the relevant adhesive sheet stored in the control device (not shown). Being controlled based on the relative positional relationship with respect to the wafer W on the sticking table 21, and at the same time, under the tensile force thereof controlled by the drive rolls 74, 80, the adhesive sheet S1 is stuck onto the rear surface of the wafer W from the end in the feed-out direction in order under the rotation and pressing force by the sticking roll 61. Owing to this, the adhesive sheet S1 is stuck onto the rear surface of the wafer W in a state the displacement is corrected. Note that the suction table 21B is arranged so as, after the above movement, to return to the initial position; i.e., to a position where the center of the wafer W coincide with the reference center line CL, and then, transfer the wafer W to the suction plate 100.

The wafer W suck on the suction plate 100 of the transfer unit 22 is transferred to the sticking plate 26 and completely bonded. And further, the wafer W is mounted onto the ring frame RF by the mounting apparatus 18; and then, the protective tape (not shown) stuck on the circuit surface is peeled off.

Next, the operation of the sticking roll 61 to stick the adhesive sheet S1 onto the wafer W will be described specifically with reference to Fig. 6 and Fig. 7.
In the present invention, two modes of sticking can be adopted as shown in Fig. 6 and Fig. 7. Fig. 6 shows a, so-called, feeding-out and sticking simultaneous mode; Fig. 7 shows a winding and sticking simultaneous mode.

In the sticking mode shown in Figs. 6(A) to 6(D), the adhesive sheet S1 is fed out to a position where the lead end SE thereof coincides with the right end of the wafer W in the figure (refer to Fig. 6(A)). Then, in this state, the sticking roll 61 is lowered by the up/down cylinders 89 to bring the lead end SE into contact with the right end of the wafer W (refer to Fig. 6(B)). When the sticking roll moving device 52 moves toward the opposite side in the diameter direction of the wafer W, while feeding out the adhesive sheet S1, the sticking roll 61 presses and sticks the adhesive sheet S1 onto the wafer W (refer to Fig. 6(D)).

Further, in the sticking mode shown in Figs. 7 (A) to 7(D), the sticking roll moving device 52 is activated to position the center of the sticking roll 61 immediately above the left end of the wafer W in the figures, and the raw strip sheet is fed out until the following state is obtained. That is, the anti lead end SE1 of the adhesive sheet S1 coincides with the left end of the wafer W in the figures; i.e., to a position where the adhesive sheet S1 faces the wafer W (refer to Fig. 7(A)). In this state, the sticking roll 61 is lowered to bring the anti lead end SE1 of the adhesive sheet S1 into contact with the left end of the wafer W (refer to Fig. 7(B)). Then, the sticking roll moving device 52 moves toward the opposite side in the diameter direction of the wafer W, and while winding the raw strip sheet L, the sticking roll 61 can press and stick the adhesive sheet S1 onto the wafer W (refer to Figs. 7(C) and 7(D)).

Therefore, according to the embodiment as described above, since the detector 60 detects the displacement of the adhesive sheet S1 during feeding out operation, when a displacement occurs, the position of the sticking table 21 can be corrected. Thus, the adhesive sheet S1 can be continuously stuck onto the wafer W without reducing the processing efficiency.

Also, being stuck with a pressure force via the release liner PS, the adhesive sheet S1 is prevented from being damaged due to direct contact with the sticking roll 61.

As described above, the best structure, method and the like for carrying out the present invention has been disclosed in the above descriptions. However, the present invention is not limited to the above description.
That is, the present invention has been illustrated and described mainly as to the particular embodiments. However, it is possible for one skilled in the art to make various modifications in shape, position, disposition or the like on the above-described embodiments without departing from the scope of the technical spirit and object of the present invention, if necessary.

For example, the sticking apparatus 16 in the embodiment has been illustrated and described as an apparatus that sticks adhesive sheet S1 for die bonding, which has a heat-sensitive adhesiveness, to the wafer W. However, another sheet, for example, a pressure-sensitive adhesive sheet may be employed. Also, the sticking apparatus 16 is applicable to a case where a dry resist film or a sheet for forming a protective film is stuck onto the wafer W.

Further, in the embodiment, an arrangement in which the adhesive sheet S1 is stuck onto the wafer W has been described. However, the sticking apparatus 16 is applicable to a case where a sheet or film is stuck onto a plate-like object other than the wafer W.

## Claims

1. A sticking apparatus, comprising:
a sticking table for supporting a plate-like object; and
a sticking unit that peels off an adhesive sheet having a plane shape corresponding to the plate-like object in the feeding process of a raw strip sheet temporarily stuck with the adhesive sheet on a release liner and sticks the sheet onto said plate-like object,
wherein the sticking apparatus is provided with: a detector disposed above a feed-out path of said raw strip sheet for detecting displacement amount in the lateral direction perpendicular to the feed-out direction of said adhesive sheet; and a displacement correction device that, when a displacement of said adhesive sheet is detected by the detector, corrects the displacement, and
wherein said detector detects the displacement amount without stopping the feed-out operation of said raw strip sheet.

2. A sticking apparatus, comprising:
a sticking table for supporting a semiconductor wafer; and
a sticking unit that peels off an adhesive sheet having a plane shape corresponding to the semiconductor wafer in the feeding process of a raw strip sheet temporarily stuck with the adhesive sheet on a release liner, and sticks the sheet onto said semiconductor wafer,
wherein the sticking apparatus is provided with: a detector disposed above a feed-out path of said raw strip sheet for detecting displacement amount in the lateral direction perpendicular to the feed-out direction of said adhesive sheet; and a displacement correction device that, when a displacement of said adhesive sheet is detected by the detector, adjusts the position of said sticking table in accordance with the displacement, and
wherein said detector detects the displacement amount without stopping the feed-out operation of said raw strip sheet.

3. A sticking apparatus, comprising:
a sticking table for supporting a plate-like object; and
a sticking unit that peels off an adhesive sheet having a plane shape corresponding to the plate-like object in the feeding process of a raw strip sheet temporarily stuck with the adhesive sheet on a release liner, and sticks the sheet onto said plate-like object,
wherein said sticking unit sticks said adhesive sheet onto said plate-like object while performing the feeding out of said adhesive sheet, pressing of the adhesive sheet and peeling off the adhesive sheet from the release liner simultaneously.

4. A sticking apparatus, comprising:
a sticking table for supporting a plate-like object; and
a sticking unit that peels off an adhesive sheet having a plane shape corresponding to the plate-like object in the feeding process of a raw strip sheet temporarily stuck with the adhesive sheet on a release liner, and sticks the sheet onto said plate-like object,
wherein said sticking unit sticks said adhesive sheet onto said plate-like object while performing winding of the adhesive sheet, pressing of the adhesive sheet and peeling off of the adhesive sheet from the release liner simultaneously from a state where said adhesive sheet is fed out to a position facing the upper surface of the plate-like object.

5. The sticking apparatus according to claim 3 or 4, further comprising: a detector disposed above a feed-out path of said raw strip sheet for detecting displacement amount of said adhesive sheet in lateral direction perpendicular to the feed-out direction thereof; and a displacement correction device that, when a displacement of said adhesive sheet is detected by the detector, corrects the displacement,
wherein the detector detects the displacement amount without stopping the feed-out operation of the raw strip sheet.

6. The sticking apparatus according to claim 1, 2 or 5,
wherein said adhesive sheet has a substantially circular shape, said detector detects a chord length of the adhesive sheet along said feed-out direction to determine said displacement amount.

7. The sticking apparatus according to claim 1, 2, 5 or 6, wherein said detectors are disposed at the both sides in lateral direction at regular intervals with respect to a reference center line along said feed-out direction.

8. The sticking apparatus according to any of claims 1 to 7, wherein said adhesive sheet is a heat-sensitive adhesive sheet for die bonding.
